# EUROPEAN PATENT SPECIFICATION

(11) **EP 4 597 139 B1**
(45) Date of publication and mention of the grant of the patent: **09.09.2026**
(21) Application number: 24275004.0
(22) Date of filing: 01.02.2024
(51) Int. Cl.: G01R 31/58, G01R 31/12, G01R 31/00, H02H 1/00

(54) **SYSTEM FOR DETECTING SERIES ARC FAULTS IN ELECTRIC CABLING**
SYSTEM ZUR ERKENNUNG VON REIHENBOGENFEHLERN IN ELEKTRISCHEN VERKABELUNGEN
SYSTÈME DE DÉTECTION DE DÉFAUTS D'ARC EN SÉRIE DANS UN CÂBLAGE ÉLECTRIQUE

(43) Date of publication of application: 06.08.2025
(73) Proprietor: Hamilton Sundstrand Corporation, Charlotte, NC 28277 (US)
(72) Inventor: BENN, Andrew J., Birmingham B14 6HH (GB); SHAH, Mital, Harrow HA3 0NH (GB); MANN, Jaspreet K, Shirley B90 1JQ (GB)
(74) Representative: Dehns

(56) References cited:
- WO-A1-2024/013186
- US-A1- 2001 029 433
- US-A1- 2016 111 870
- US-A1- 2020 191 856
- US-A1- 2022 099 724

## Description

### TECHNICAL FIELD

This disclosure is concerned with a system for detecting series arcing in electrical cabling such as in high power load supply systems. Such systems include, for example, motor drive or other high load drive systems in aircraft.

### BACKGROUND

Electrical systems include electrical cabling between a power supply and the load or loads to be driven. In some applications, such cabling may be very long and may be subject to wear or damage over its length, especially where the cabling is located in harsh environments subject to e.g. high temperature and/or vibrational variations or effects. Such wear or damage can cause arcing in the system. Parallel arcing, across cables, is relatively easy to detect using circuit breaker circuitry. Series arcing, along a cable, however, does not cause an increase in current and is, therefore, more difficult to detect, and may cause significant damage to the system and/or loads via thermal effects before current detection systems are able to disconnect the circuit.

Such electrical systems are finding application in more and more applications including more applications where high voltages are present. For example, there is a drive to increase the degree of electrical control in aircraft (so-called more electric aircraft (MEA) or all electric aircraft (AEA)). In such aircraft DC distribution voltages can be very high - in the range of e.g. 540 V dc, for driving high power loads such as aircraft motor drives. Failure or delay in detecting series arcing can have serious and even catastrophic consequences.

US 2022/0099724 proposes a system for detecting series arcing in electrical cabling using electrical circuitry to inject current into a monitoring line to eliminate the effect of a voltage drop in a main power line. This solution requires additional, complex circuitry in the sensing line (which, therefore, needs to have a corresponding large diameter). For high power systems, a significant power circuit would be required to provide a current controlled output at high voltage. Such a system is also vulnerable to the effects of noise in the dc voltage which can result in false arcing detection.

There is, therefore, a desire for an improved system for series arc detection.

### SUMMARY

According to the disclosure, there is provided a power supply system as defined in claim 1; further embodiments are defined in the corresponding dependent claims 2-15. The power supply system comprises a DC power supply, a load to be powered by the power supply, and a DC electrical conductor electrically connected at a first end to the power supply and at a second end to the load, the system further comprises a fault detection system configured to detect a series arc event in the DC electrical conductor, the fault detection system comprising: a sense line conductor having a length the same as the DC electrical conductor and electrically connected at a first end to the power supply and at a second end to the load, the sense line having a high impedance termination at the second end; a differential amplifier having a first input connected to the sense line conductor at a first terminal and a second input connected to the DC electrical conductor at a second terminal, and an output providing a voltage differential output; and a comparator to compare the voltage differential output to a predetermined voltage differential threshold, the comparator providing a fault output dependent on the comparison.

In embodiments, a high-pass filter is connected between the output of the differential amplifier and the comparator.

The comparator output is configured to generate a fault indication in response to the voltage differential output exceeding the threshold.

The predetermined voltage differential threshold is a set point or a dynamic threshold.

The fault detection system is integrated with other circuitry of the load.

The DC electrical conductor comprises a positive line and a negative line connected, respectively, to a positive and a negative terminal of the power supply.

In some embodiments, the power supply is a power generator.

In some embodiments, the power supply is a battery.

The load is a motor drive, and a motor is arranged to be driven by the motor drive. The motor drive comprises switching inverter circuitry and further comprises motor drive monitor and control circuitry.

The system is an aircraft power supply system, and the load is a motor drive configured to drive an aircraft motor

### BRIEF DESCRIPTION

Examples of the system according to the disclosure will now be described with reference to the drawings. It should be noted that these are examples only for the better understanding of the scope of the invention as defined in the appended claims.
Figure 1 is a simple diagram of a system according to the disclosure.
Figure 2 shows arc detection circuitry according to the disclosure.

### DETAILED DESCRIPTION

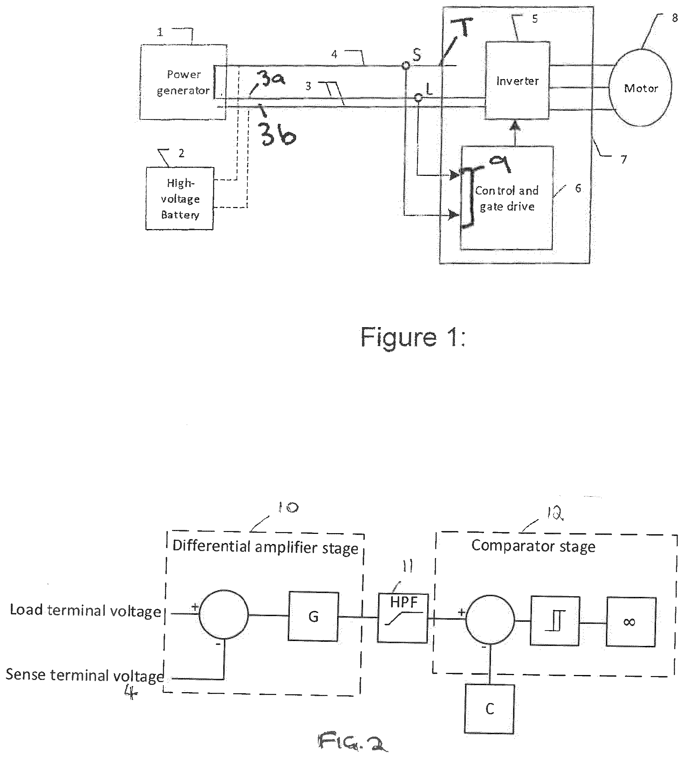

Figure 1 shows a power drive system having a power supply 1,2 which may be a power generator 1 and/or a battery - e.g. high voltage battery 2 to provide a DC link voltage. A DC conductor or DC link main line 3 (referred to herein as the DC link harness 3) connects the battery/power generator to the load or loads to be driven e.g. a motor drive 7 for driving a motor 8. The DC link harness 3 includes a positive line connected to the positive terminal of the power supply and to a positive terminal of the load, and a negative line connected to the negative terminal of the power supply and to a negative terminal of the load. In this example, the motor drive 7 includes a switching inverter 5, powered by the DC supply, to drive the AC motor 8, as is known in the power supply or power converter art. In the example, the motor drive 7 also includes control and gate drive circuitry 6 to monitor and control the motor drive.

As described above, any arcing phenomenon on either the positive or the negative line along the length of the harness from power supply to load could cause faulty or no operation of the load (here, the motor drive and the motor).

To allow for reliable detection of a series arc, the system according to this disclosure adds a sense line, or sense harness 4, of the same length as the DC link harness, extending in parallel with the DC link harness from the power supply to the load. The sense line(s) may be provided for both DC positive and DC negative as part of a harness, or for just one of those lines. The sense line 4 has a high impedance termination T at the load end such that it does not draw current. Termination may be provided by a resistor network from the sense terminal to the load terminal of the opposite polarity. The resistor network may be made up of multiple high resistances to produce a high impedance termination. The high impedance will limit the current flow in the sense harness to a low value which allows for a small conductor cross-sectional area.

An arc detection circuit 9 is provided across the sense line 4, at a source terminal S and the DC link harness 3 at a load terminal L.

The arc detection circuit 9 may include a differential amplifier 10 having a first input connected to the sense line 4 at the source terminal S and a second input connected to the DC link harness at the load terminal L to provide an output indicative of the voltage differential between the sense line and the DC link harness. The output of the differential amplifier 10 may be provided to a high pass filter 11 to attenuate unwanted low frequency noise caused by e.g. inverter operation or load transients. It is only necessary, for arc detection, to look at high frequencies and so all of the DC components can be removed by the filter. A comparator 12 may then compare the filtered output with a predetermined threshold. The threshold may be a predetermined set point e.g. using a comparator, or can be set as a dynamic threshold using a programmable control system e.g. DSP or FPGA. If the output exceeds the threshold, this is indicative of a series arc. The output may be used to provide an alert or alarm or to disconnect the power circuit from the load e.g. by setting a system fault flag or in some other known manner for indicating fault detection.

In the example shown in Fig. 1, the arc detection circuit 9 is shown as part of the motor drive control circuitry block but in other examples, the arc detection circuitry may be provided as a separate block or may be integrated in other existing blocks.

In normal operation, the high frequency differential between terminal S and terminal L is negligible and below the threshold, so no fault will be reported and the system will continue to operate as normal. If a series arc event occurs, the DC voltage at the load terminal L will fluctuate due to anode and cathode voltage drop and a high frequency component will be observed at terminal L. As no arcing occurs on the sense line, no high frequency voltage variations are observed at terminal S. This then results in a high frequency, voltage differential between the terminals L and S which is detected by and provided as output from the differential amplifier 10 and which will, after filtering, exceed the predetermined threshold so provide a fault indication. Based on this indication, the system may take appropriate action as determined by the application and system design.

By reliably and quickly detecting series arcing in this way, this system can avoid false detection but can also cause system shut down before complete failure of or damage to the load and can allow preventative maintenance to be performed. The detection circuitry can be integrated into and, therefore, make use of existing circuitry present in typical load drive electronics. The reliable arc detection means that such power systems can be used in new and safety critical high voltage applications.

## Claims

1. A power supply system comprising a DC power supply (1,2), a load (7) configured to be powered by the DC power supply, and a DC electrical conductor (3) electrically connected at a first end to the DC power supply and at a second end to the load, the system further comprising a fault detection system (4, 9) configured to detect a series arc event in the DC electrical conductor (3), the fault detection system comprising:
a sense line conductor (4) having a length the same as the DC electrical conductor and electrically connected at a first end to the DC power supply and at a second end to the load, the sense line having
a high impedance termination at the second end;
a differential amplifier (10) having a first input connected to the sense line conductor at a first terminal (S) and a second input connected to the DC electrical conductor (3) at a second terminal (L), and an output providing a voltage differential output; and
a comparator (12) configured to compare the voltage differential output to a predetermined voltage differential threshold, the comparator configured to provide a fault output dependent on the comparison.

2. The power supply system of claim 1, further comprising a high-pass filter (11) connected between the output of the differential amplifier and the comparator.

3. The power supply system of claim 1 or 2, wherein the comparator output is configured to generate a fault indication in response to the voltage differential output exceeding the threshold.

4. The power supply system of any preceding claim, wherein the predetermined voltage differential threshold is a set point.

5. The power supply system of any of claims 1 to 3, wherein the predetermined voltage differential threshold is a dynamic threshold.

6. The power supply system of any preceding claim, wherein the fault detection system (9) is integrated with other circuitry of the load.

7. The power supply system of any preceding claim, wherein the DC electrical conductor (3) comprises a positive line (3a) and a negative line (3b) connected, respectively, to a positive and a negative terminal of the DC power supply.

8. The power supply system of any preceding claim, wherein the DC power supply is a power generator (1).

9. The power supply system of any of claims 1 to 7, wherein the DC power supply is a battery (2).

10. The power supply system of any preceding claim, wherein the load is a motor drive (7).

11. The power supply system of claim 10, further comprising a motor (8) arranged to be driven by the motor drive (7).

12. The power supply system of claim 10 or 11, wherein the motor drive comprises switching inverter circuitry (5).

13. The power supply system of any of claims 10 to 12, wherein the motor drive further comprises motor drive monitor and control circuitry.

14. The power supply system of any preceding claim, being an aircraft power supply system.

15. The power supply system of claim 14, wherein the load is a motor drive configured to drive an aircraft motor.

## Patentansprüche

1. Stromversorgungssystem, umfassend eine Gleichstromversorgung (1, 2), eine Last (7), die dazu konfiguriert ist, von der Gleichstromversorgung mit Strom versorgt zu werden, und einen elektrischen Gleichstromleiter (3), der an einem ersten Ende mit der Gleichstromversorgung und an einem zweiten Ende mit der Last elektrisch verbunden ist, wobei das System ferner ein Fehlererkennungssystem (4, 9) umfasst, das dazu konfiguriert ist, ein Reihenbogenereignis in dem elektrischen Gleichstromleiter (3) zu erkennen, wobei das Fehlererkennungssystem Folgendes umfasst:
einen Messleitungsleiter (4), der die gleiche Länge wie der elektrische Gleichstromleiter aufweist und an einem ersten Ende mit der Gleichstromversorgung und an einem zweiten Ende mit der Last elektrisch verbunden ist, wobei die Messleitung an dem zweiten Ende einen hochohmigen Abschluss aufweist;
einen Differenzverstärker (10), der einen ersten Eingang, der an einem ersten Anschluss (S) mit dem Messleitungsleiter verbunden ist, und einen zweiten Eingang, der an einem zweiten Anschluss (L) mit dem elektrischen Gleichstromleiter (3) verbunden ist, und einen Ausgang, der einen Spannungsdifferenzausgang bereitstellt, aufweist; und
einen Komparator (12), der dazu konfiguriert ist, den Spannungsdifferenzausgang mit einem vorbestimmten Spannungsdifferenzschwellenwert zu vergleichen, wobei der Komparator dazu konfiguriert ist, einen Fehlerausgang abhängig von dem Vergleich bereitzustellen.

2. Stromversorgungssystem nach Anspruch 1, ferner umfassend ein Hochpassfilter (11), das zwischen dem Ausgang des Differenzverstärkers und dem Komparator verbunden ist.

3. Stromversorgungssystem nach Anspruch 1 oder 2, wobei der Komparatorausgang dazu konfiguriert ist, eine Fehlerangabe als Reaktion darauf zu erzeugen, dass der Spannungsdifferenzausgang den Schwellenwert überschreitet.

4. Stromversorgungssystem nach einem der vorhergehenden Ansprüche, wobei der vorbestimmte Spannungsdifferenzschwellenwert ein Sollwert ist.

5. Stromversorgungssystem nach einem der Ansprüche 1 bis 3, wobei der vorbestimmte Spannungsdifferenzschwellenwert ein dynamischer Schwellenwert ist.

6. Stromversorgungssystem nach einem der vorhergehenden Ansprüche, wobei das Fehlererkennungssystem (9) in eine andere Schaltung der Last integriert ist.

7. Stromversorgungssystem nach einem der vorhergehenden Ansprüche, wobei der elektrische Gleichstromleiter (3) eine positive Leitung (3a) und eine negative Leitung (3b) umfasst, die mit einem positiven bzw. einem negativen Anschluss der Gleichstromversorgung verbunden sind.

8. Stromversorgungssystem nach einem der vorhergehenden Ansprüche, wobei die Gleichstromversorgung ein Stromgenerator (1) ist.

9. Stromversorgungssystem nach einem der Ansprüche 1 bis 7, wobei die Gleichstromversorgung eine Batterie (2) ist.

10. Stromversorgungssystem nach einem der vorhergehenden Ansprüche, wobei die Last ein Motorantrieb (7) ist.

11. Stromversorgungssystem nach Anspruch 10, ferner umfassend einen Motor (8), der dazu angeordnet ist, durch den Motorantrieb (7) angetrieben zu werden.

12. Stromversorgungssystem nach Anspruch 10 oder 11, wobei der Motorantrieb eine Schaltwechselrichterschaltung (5) umfasst.

13. Stromversorgungssystem nach einem der Ansprüche 10 bis 12, wobei der Motorantrieb ferner eine Motorantriebsüberwachungs- und -steuerungsschaltung umfasst.

14. Stromversorgungssystem nach einem der vorhergehenden Ansprüche, wobei es sich um ein Luftfahrzeugstromversorgungssystem handelt.

15. Stromversorgungssystem nach Anspruch 14, wobei die Last ein Motorantrieb ist, der dazu konfiguriert ist, einen Luftfahrzeugmotor anzutreiben.

## Revendications

1. Système d'alimentation électrique comprenant une alimentation CC (1,2), une charge (7) configurée pour être alimentée par l'alimentation CC, et un conducteur électrique CC (3) connecté électriquement au niveau d'une première extrémité à l'alimentation CC et au niveau d'une seconde extrémité à la charge, le système comprenant en outre un système de détection de défaut (4, 9) configuré pour détecter un événement d'arc en série dans le conducteur électrique CC (3), le système de détection de défaut comprenant :
un conducteur de ligne de détection (4) présentant une longueur identique à celle du conducteur électrique CC et connecté électriquement au niveau d'une première extrémité à l'alimentation CC et au niveau d'une seconde extrémité à la charge, la ligne de détection présentant une terminaison à haute impédance au niveau de la seconde extrémité ;
un amplificateur différentiel (10) ayant une première entrée connectée au conducteur de ligne de détection au niveau d'une première borne (S) et une seconde entrée connectée au conducteur électrique CC (3) au niveau d'une seconde borne (L), et une sortie fournissant une sortie différentielle de tension ; et
un comparateur (12) configuré pour comparer la sortie différentielle de tension à un seuil différentiel de tension prédéterminé, le comparateur étant configuré pour fournir une sortie de défaut dépendante de la comparaison.

2. Système d'alimentation électrique selon la revendication 1, comprenant en outre un filtre passe-haut (11) connecté entre la sortie de l'amplificateur différentiel et le comparateur.

3. Système d'alimentation électrique selon la revendication 1 ou 2, dans lequel la sortie du comparateur est configurée pour générer une indication de défaut en réponse au fait que la sortie différentielle de tension dépasse le seuil.

4. Système d'alimentation électrique selon une quelconque revendication précédente, dans lequel le seuil différentiel de tension prédéterminé est un point de consigne.

5. Système d'alimentation électrique selon l'une quelconque des revendications 1 à 3, dans lequel le seuil différentiel de tension prédéterminé est un seuil dynamique.

6. Système d'alimentation électrique selon une quelconque revendication précédente, dans lequel le système de détection de défaut (9) est intégré à un autre circuit de la charge.

7. Système d'alimentation électrique selon une quelconque revendication précédente, dans lequel le conducteur électrique CC (3) comprend une ligne positive (3a) et une ligne négative (3b) connectées, respectivement, à une borne positive et à une borne négative de l'alimentation CC.

8. Système d'alimentation électrique selon une quelconque revendication précédente, dans lequel l'alimentation CC est un générateur de puissance (1).

9. Système d'alimentation électrique selon l'une quelconque des revendications 1 à 7, dans lequel l'alimentation CC est une batterie (2).

10. Système d'alimentation électrique selon une quelconque revendication précédente, dans lequel la charge est un variateur de vitesse (7).

11. Système d'alimentation électrique selon la revendication 10, comprenant en outre un moteur (8) agencé pour être entraîné par le variateur de vitesse (7).

12. Système d'alimentation électrique selon la revendication 10 ou 11, dans lequel le variateur de vitesse comprend un circuit d'onduleur de commutation (5).

13. Système d'alimentation électrique selon l'une quelconque des revendications 10 à 12, dans lequel le variateur de vitesse comprend en outre un circuit de surveillance et de commande de variateur de vitesse.

14. Système d'alimentation électrique selon une quelconque revendication précédente, qui est un système d'alimentation électrique d'aéronef.

15. Système d'alimentation électrique selon la revendication 14, dans lequel la charge est un variateur de vitesse configuré pour entraîner un moteur d'aéronef.
